# EUROPEAN PATENT SPECIFICATION

(11) **EP 3 550 314 B1**
(45) Date of publication and mention of the grant of the patent: **23.02.2022**
(21) Application number: 18165370.0
(22) Date of filing: 03.04.2018
(51) Int. Cl.: G01R 31/317

(54) **TESTING SYSTEM AND METHOD FOR EFFICIENTLY TESTING HIGH-FREQUENCY COMMUNICATIONS DEVICES**
TESTSYSTEM UND VERFAHREN ZUM EFFIZIENTEN TESTEN VON HOCHFREQUENZKOMMUNIKATIONSVORRICHTUNGEN
SYSTÈME D'ESSAI ET PROCÉDÉ D'ESSAI EFFICACE DE DISPOSITIFS DE COMMUNICATION HAUTE FRÉQUENCE

(43) Date of publication of application: 09.10.2019
(73) Proprietor: Rohde & Schwarz GmbH & Co. KG, 81671 München (DE)
(72) Inventor: Corbett, Rowell, 81545 München (DE); Benoit, Derat, 81927 München (DE)
(74) Representative: Rupp, Christian

(56) References cited:
- EP-A1- 2 656 677
- EP-A1- 2 889 957
- EP-A1- 2 919 508
- GB-A- 2 318 010
- JP-A- 2009 055 153
- US-A1- 2011 059 689
- US-A1- 2013 021 912
- US-A1- 2016 204 881
- US-B1- 7 539 489

## Description

The invention relates to testing high-frequency communications devices, especially 5G communications devices.

During recent years, the frequencies employed in high-frequency communications have constantly risen. The necessary hardware effort to test high-frequency communications devices have risen accordingly. Especially with presently envisaged 5G communications systems, performing tests on the respective communications devices will require measuring devices of very high hardware complexity.

For example, the document WO 2016/159632 A1 shows a measuring device for performing measurements on a 5G communications device. Documents JP 2009 055153 A, US 2016/204881 A1, US 2013/021912 A1 and GB 2 318 010 A disclose further examples of testing systems for testing wireless communication devices.

The state of the art is disadvantageous since it requires a measuring device able to perform 5G communications in a full duplex manner.

Accordingly, the object of the invention is to provide a testing system and testing method, which allow for a measurement of the performance of a device under test without requiring complex hardware.

The object is solved by the features of independent claim 1 for the system and by the features of independent claim 13 for the method. Further, it is solved by the features of claim 14 for the associated computer program. The dependent claims contain further developments.
- FIG. 1: shows a first exemplary measuring device;
- FIG. 2: shows a second exemplary measuring device;
- FIG. 3: shows an example, not covered by the claimed invention, of the measuring system;
- FIG. 4: shows an embodiment of the inventive measuring system;
- FIG. 5: shows a detail of an embodiment of the inventive measuring system; and
- FIG. 6: shows an embodiment of the inventive measuring method in a flow diagram.

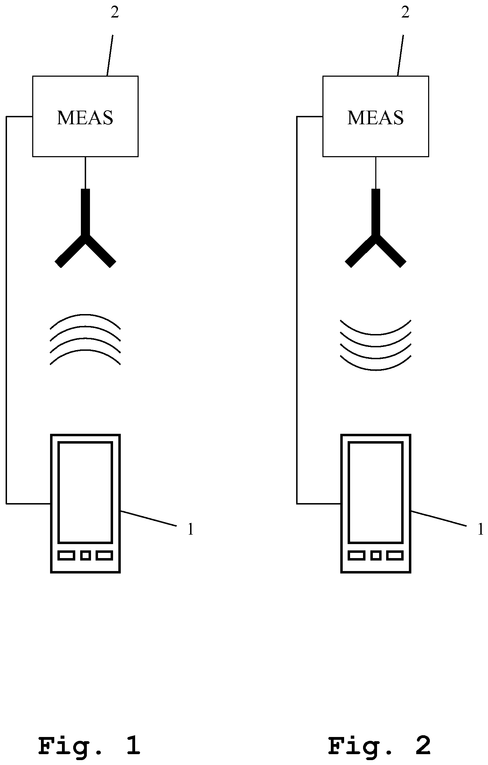

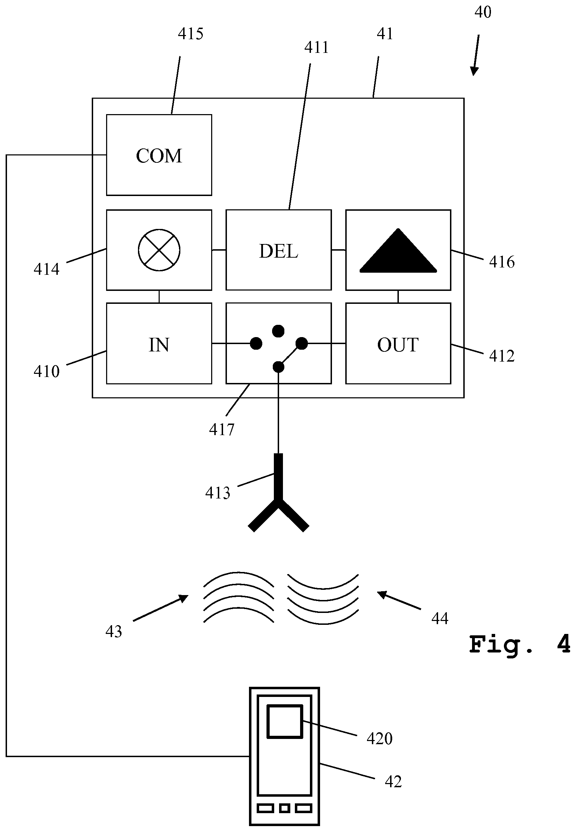

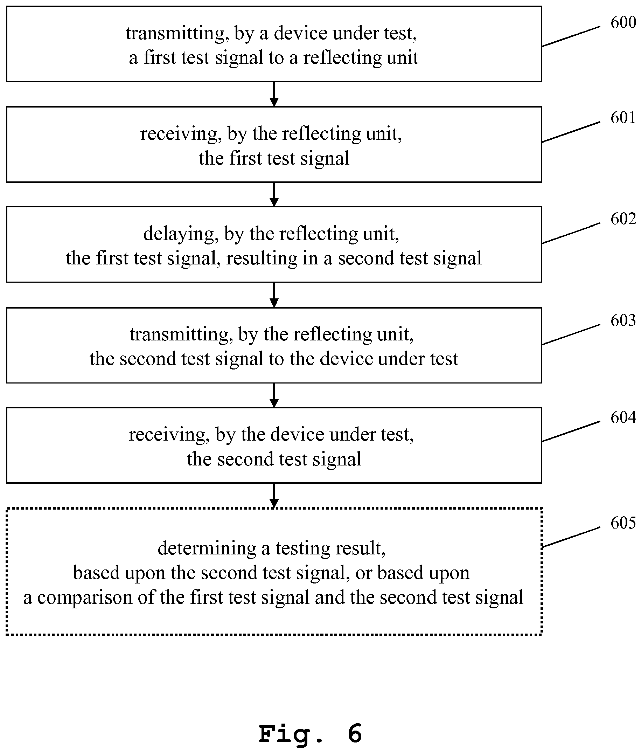

First, we demonstrate the disadvantages of an exemplary measuring system with regard to FIG. 1 and FIG. 2. Along FIG. 4 - FIG. 5, the construction and function of different embodiments of the inventive measuring system are shown. Finally, with regard to FIG. 6, an embodiment of the inventive measuring method is described in detail. Similar entities and reference numbers in different figures have been partially omitted.

In FIG. 1, an exemplary measuring system is shown. The measuring system comprises a measuring device 2. The measuring device 2 is connected to a device under test 1 through a cable connection. The measuring device 2 instructs the device under test 1 through the cable connection to emit a test signal wirelessly, which is then received by an antenna of the measuring device 2. From the received test signal, the measuring device 2 determines a test result.

A further exemplary measuring system is shown in FIG. 2. It comprises a measuring device 2, as in FIG. 1. The measuring device 2 again is connected to the device under test 1 through a wired connection. The measuring device 2 instructs the device under test 1 to receive a test signal emitted wirelessly by an antenna of the measuring device 2. The device under test 1 then receives the test signal wirelessly and hands a digital representation of the received test signal back to the measuring device 2, which determines a test result based thereupon.

The two exemplary test systems of FIG. 1 and FIG. 2 have the disadvantage that they require a very complex standalone measuring device 2 which is able to perform a full communication with the device under test.

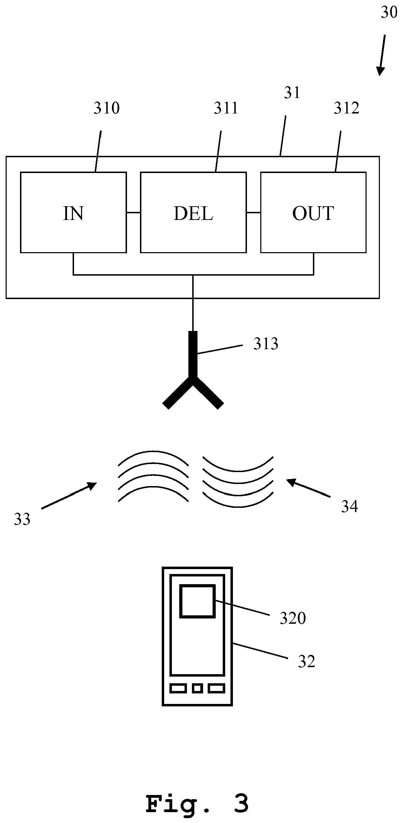

In FIG. 3, an example not covered by the claimed invention of a test system 30 is shown. The testing system 30 comprises a reflecting unit 31 and a device under test 32. The reflecting unit 31 comprises an input 310, a delay unit 311 and an output 312. Optionally, it furthermore comprises an antenna 313.

The antenna 313 is then connected to the input 310, which in turn is connected to the delay unit 311. The delay unit 311 is moreover connected to the output 312, which again is connected to the antenna 313. Preferably, the antenna 313 is a horn antenna.

Also preferably, only one antenna is used for input and output. In another example not covered by the claimed invention though, a separate antenna can be used for input and output. In a further example not covered by the claimed invention, a single antenna having two polarizations can be used. In this case, the input is connected to a first polarization direction, while the output is connected to the second polarization direction. Preferably the second polarization direction is orthogonal with respect to the first polarization direction.

The device under test 32 moreover comprises a testing module 320.

When performing a test, the internal hardware of the device under test 32, especially the testing module 320 is used for generating and receiving test signals, in order to test the functionality of the device under test 32. The reflecting unit 31 merely serves the purpose of receiving a test signal from the device under test and returning it to the device under test after a delay time. This significantly reduces the necessary hardware complexity for performing the test.

In the following, details of performing a test are described along FIG. 3. First, the testing module 320 of the device under test 32 generates a first test signal 33 and transmits it to the reflecting unit 31. The first test signal 33 is received by the antenna 313 and handed to the input 310. The input 310 receives the first test signal 33 from the testing module 320. The first test signal 33 is then handed on to the delay unit 311, which delays the first test signal by a delay time, resulting in a second test signal 33, which is then handed to the output 312, which transmits it, by use of the antenna 313 back to the device under test 32, as second test signal 34.

The testing module 320 of the device under test 32 receives the second test signal 34 and determines a test result therefrom. Also a comparison of the first test signal 33 and the second test signal 34 by the testing unit 320 can be performed to determine the test result. Especially by using only analog components within the reflection unit 31, the complexity can be kept at a minimum.

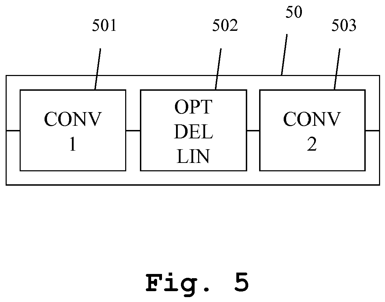

For example, the delay unit can be an electrical delay unit. Then, for example a filter or a capacitor are used to introduce the delay into the first test signal 33, resulting in the second test signal 34. If a longer delay time is necessary, advantageously an optical delay unit is used. This is shown in FIG. 5.

In FIG. 4, an embodiment of the inventive testing system 40 is shown. The testing system 40 here comprises a reflection unit 41 and a device under test 42. The reflection unit comprises an antenna 413 connected to a switch 417, which is moreover connected to an input 410. The input 410 is furthermore connected to a mixer 414, which is connected to a delay unit 411. The delay unit 411 is moreover connected to an amplifier 416, which is furthermore connected to an output 412, which is also connected to the switch 417.

Moreover, the reflection unit 41 comprises a communication unit 415 which is connected to the device under test 42 through a cable connection. The communication unit is moreover connected to the input 410, the output 412, the switch 417, the mixer 414, the delay unit 411 as well as the amplifier 416.

It is important to note that the position of the mixer 414 is not fixed. The mixer 414 can also be arranged on the output side of the delay unit 411. The same is true for the amplifier 416. It can also be placed on the input side of the delay unit 411. The switch has three switch positions. In a first switch position, the antenna 413 is connected to this input 410. In a second switch position, the antenna 413 is connected to the output 412. In a third switch position, the antenna 413 is connected to no further component. In this third switch setting, the reflection unit 41 is literally deactivated. This is useful for automated testing procedures, in which a baseline reception condition without reflected the second testing signal is to be measured.

The device under test 42 comprises a testing unit 420.

When performing a test, the testing unit 420 of the device under test 42 emits a first test signal 43, which is received by the antenna 413. In the first switch setting, the switch 417 connects the antenna 413 to the input 410. The input 410 then receives the first test signal and hands it to the mixer 411. The mixer then alters the frequency of the first test signal. It is important to note that in this figure, obvious components of the mixer, such as a local oscillator and a filter are not displayed. The frequency-changed first test signal is then handed to the delay unit 411, which delays it by a delay time, resulting in a second test signal, which is handed to the amplifier 416. The amplifier 416 amplifies the signal and hands it to the output 412. The output 412 transmits the second test signal 44 through the switch 417 and the antenna 413, while the switch 417 is in the second switch position, connecting the antenna 413 to the output 412.

The second test signal 44 is received by the device under test 42, especially by the testing module 420. From the received second test signal 44 and/or from a comparison of the first test signal 43 and the second test signal 44, the testing unit 420 determines a testing result.

It is important to note that the mixer 414, the amplifier 416, and the communication unit 415 are optional components. Therefore, also their respective functions are optional.

Moreover, the communication unit 415 is adapted to receive signals from the device under test 42, especially from the testing unit 420 instructing the different units of the reflection unit 41 to operate. Especially, the testing unit 420 can transmit signals including parameters of operation for the different units. For example, the switch 417 can be instructed to connect the antenna 413 to the input 410 in the first switch setting, to connect the antenna 413 to the output 412 in the second switch setting or to connect the antenna 413 to none of the two in the third switch position. Also, by these parameters, the mixer can be controlled to alter the frequency to a specific frequency. Moreover, by use of these parameters, the amount of delay time of the delay unit 411 can be set. Moreover, by use of these parameters, an amplification factor of the amplifier 416 can be set. Also the switch can be configured to switch between different antennas or antenna polarization directions.

Instead of using a switch, a first antenna or antenna polarization direction can be connected to the input 410, while a second antenna or antenna polarization direction is connected to the output 412.

In FIG. 5, an embodiment of the inventive testing system is shown. Especially here, details of the construction of the delay unit 50 are shown. The delay unit 50 shown here can be employed as one of the delay units 311 or 411 of FIG. 3 and FIG. 4.

The delay unit 50 comprises an analog electrical-optical converter 501, which is connected to an optical delay line 502, which in turn is connected to an analog optical-electrical converter 403.

When receiving the first test signal from the input 310 or the mixer 414, the analog electrical-optical converter 501 converts the first test signal, which is an analog signal, into a first optical signal, which also is an analog optical signal. This first optical signal is then handed to the optical delay line 502, which delays it by a delay time. For example, the optical delay line 502 is a coil of fiber-optic cable. The resulting second optical signal is handed to the analog optical-electrical converter 503, which converts it to the second test signal, to be output to the output 312 or the amplifier 416 of FIG. 4.

Finally, in FIG. 6, an embodiment of the inventive testing method is shown in a flow diagram. In a first step 600, a first test signal is transmitted by a device under test to a reflecting unit. In a second step 601, the first test signal is received by the reflecting unit. In a third step 602, the reflecting unit delays the first test signal, resulting in a second test signal. In a fourth step 603, the second test signal is transmitted by the reflecting unit back to the device under test. In a fifth step 604, the device under test receives the second test signal. In a final optional step 605, the device under test determines a testing result based upon the second test signal or based upon a comparison of the first test signal and the second test signal.

It is important to note that the testing system shown in FIG. 3 - 5 very closely relates to the testing method shown in FIG. 6. Therefore, all elaborations regarding the testing system are also valid for the testing method and vice-versa.

## Claims

1. A testing system for testing wireless communication devices, comprising
- a reflecting unit (31, 41), and
- a device under test (32, 42), which comprises a testing module (320, 420) and is configured to
- transmit a first test signal (33, 43) to the reflecting unit (31, 41), and
- receive a second test signal (34, 44) from the reflecting unit (31, 41),
wherein the reflecting unit (31, 41) comprises
- an input (310, 410), configured for receiving the first test signal (33, 43) from the testing module (320, 420),
- a delay unit (50, 311, 411), configured for delaying the first test signal (33, 43), resulting in the second test signal (34, 44), and
- an output (312, 412), configured for transmitting the second test signal (34, 44) to the testing module (320, 420), **characterized in that** the delay unit (50, 311, 411) is an optical delay unit (50, 311, 411), comprising
- an analog electrical-optical converter (501), configured for converting the first test signal (33, 43) to a first optical signal,
- an optical delay line (502), configured for delaying the first optical signal, resulting in a second optical signal, and
- an analog optical-electrical converter (503), configured for converting the second optical signal to the second test signal (34, 44).

2. The testing system of claim 1,
wherein the testing module (320, 420) is configured to determine a testing result, based upon the second test signal (34, 44), or a comparison of the first test signal (33, 43) and the second test signal (34, 44).

3. The testing system of claim 1 or 2,
wherein the delay unit (50, 311, 411) is an analog delay unit (50, 311, 411).

4. The testing system of any of the claims 1 to 3, wherein the delay unit (311, 411) is an electrical delay unit (311, 411), especially a filter or a capacitor.

5. The testing system of any of the claims 1 to 4, wherein the device under test (32, 42) and the delay unit (50, 311, 411) are synchronized, and
wherein the testing module (320, 420) is configured to not transmit any further signal, until the second test signal (34, 44) has been received.

6. The testing system of any of the claims 1 to 5, wherein the reflecting unit (31, 41) comprises an amplifier (416), configured to amplify
- the first test signal before entering the delay unit, or
- the second test signal (44) after leaving the delay unit (411).

7. The testing system of any of the claims 1 to 6, wherein the reflecting unit (31, 41) comprises a mixer (414), configured to shift
- the first test signal (43) to a different frequency before entering the delay unit (411), or
- the second test signal to a different frequency after leaving the delay unit.

8. The testing system of any of the claims 1 to 7, wherein the reflecting unit (31, 41) comprises a switch (417), configured to interrupt
- the first test signal (43) from being handed to the delay unit (411), and/or
- the second test signal (44) from being handed to the output (412).

9. The testing system of claim 8,
wherein the switch (417) is configured for performing the interruption based upon an interruption signal received by the reflection device from the device under test (32, 42), and/or the testing module (320, 420), and/or an external interface.

10. The testing system of any of the claims 1 to 9, wherein the reflecting unit (31, 41) comprises
- a first port for receiving the first test signal (33, 43), and
- a second port for transmitting the second test signal (34, 44).

11. The testing system of any of the claims 1 to 10, wherein the delay unit (50, 311, 411) comprises an adjusting unit, configured for adjusting a delay time between the first test signal (33, 43) and the second test signal (34, 44).

12. The testing system of claim 11,
wherein the adjusting unit is configured for adjusting the time between the first test signal (33, 43) and the second test signal (34, 44) based upon a delay time signal received by the reflection device from the device under test (32, 42), and/or the testing module (320, 420) and/or an external interface.

13. A testing method for testing wireless communications devices, comprising
- transmitting (600), by a device under test (32, 42), a first test signal (33, 43) to a reflecting unit (31, 41),
- receiving (601), by the reflecting unit (31, 41), the first test signal (33, 43),
- delaying (602), by a delay unit (50, 311, 411) in the reflecting unit (31, 41), the first test signal (33, 43), resulting in a second test signal (34, 44),
wherein the delay unit (50, 311, 411) is an optical delay unit (50, 311, 411), comprising an analog electrical-optical converter (501), configured for converting the first test signal (33, 43) to a first optical signal, an optical delay line (502), configured for delaying the first optical signal, resulting in a second optical signal, and an analog optical-electrical converter (503), configured for converting the second optical signal to the second test signal (34, 44);
- transmitting (603), by the reflecting unit (31, 41), the second test signal (34, 44) to the device under test (32, 42), and
- receiving (604), by the device under test (32, 42), the second test signal (34, 44).

14. Computer program with a program code for performing all steps of the testing method according to claim 13 when the computer program code is loaded and runs on a computer or a digital signal processor, which is connected to the reflecting unit (31, 41), the device under test (32, 42) and a testing module (320, 420).

## Patentansprüche

1. Testsystem zum Testen von drahtlosen Kommunikationsvorrichtungen, umfassend
- eine Reflexionseinheit (31, 41), und
- eine zu testende Vorrichtung (32, 42), die ein Testmodul (320, 420) umfasst und konfiguriert ist zum
- Senden eines ersten Testsignals (33, 43) an die Reflexionseinheit (31, 41), und
- Empfangen eines zweiten Testsignals (34, 44) von der Reflexionseinheit (31, 41),
wobei die Reflexionseinheit (31, 41) Folgendes umfasst
- einen Eingang (310, 410), der konfiguriert ist, um das erste Testsignal (33, 43) von dem Testmodul (320, 420) zu empfangen,
- eine Verzögerungseinheit (50, 311, 411), die konfiguriert ist, um das erste Testsignal (33, 43) zu verzögern, was zu dem zweiten Testsignal (34, 44) führt, und
- einen Ausgang (312, 412), der konfiguriert ist, um das zweite Testsignal (34, 44) an das Testmodul (320, 420) zu senden, **dadurch gekennzeichnet, dass** die Verzögerungseinheit (50, 311, 411) eine optische Verzögerungseinheit (50, 311, 411) ist, die Folgendes umfasst
- einen elektro-optischen Analogwandler (501), der konfiguriert ist, um das erste Testsignal (33, 43) in ein erstes optisches Signal umzuwandeln,
- eine optische Verzögerungsleitung (502), die konfiguriert ist, um das erste optische Signal zu verzögern, was zu einem zweiten optischen Signal führt, und
- einen optisch-elektrischen Analogwandler (503), der konfiguriert ist, um das zweite optische Signal in das zweite Testsignal (34, 44) umzuwandeln.

2. Testsystem nach Anspruch 1,
wobei das Testmodul (320, 420) konfiguriert ist, um ein Testergebnis basierend auf dem zweiten Testsignal (34, 44) oder einem Vergleich des ersten Testsignals (33, 43) und des zweiten Testsignals (34, 44) zu bestimmen.

3. Testsystem nach Anspruch 1 oder 2,
wobei die Verzögerungseinheit (50, 311, 411) eine analoge Verzögerungseinheit (50, 311, 411) ist.

4. Testsystem nach einem der Ansprüche 1 bis 3,
wobei die Verzögerungseinheit (311, 411) eine elektrische Verzögerungseinheit (311, 411) ist, insbesondere ein Filter oder ein Kondensator.

5. Testsystem nach einem der Ansprüche 1 bis 4,
wobei die zu testende Vorrichtung (32, 42) und die Verzögerungseinheit (50, 311, 411) synchronisiert sind, und
wobei das Testmodul (320, 420) konfiguriert ist, um kein weiteres Signal zu senden, bis das zweite Testsignal (34, 44) empfangen worden ist.

6. Testsystem nach einem der Ansprüche 1 bis 5, wobei die Reflexionseinheit (31, 41) einen Verstärker (416) umfasst, der konfiguriert ist, um
- das erste Testsignal zu verstärken, bevor es in die Verzögerungseinheit eintritt, oder
- das zweite Testsignal (44) zu verstärken, nachdem es die Verzögerungseinheit (411) verlassen hat.

7. Testsystem nach einem der Ansprüche 1 bis 6, wobei die Reflexionseinheit (31, 41) einen Mischer (414) umfasst, der konfiguriert ist, um
- das erste Testsignal (43) auf eine andere Frequenz zu verschieben, bevor es in die Verzögerungseinheit (411) eintritt, oder
- das zweite Testsignal auf eine andere Frequenz zu verschieben, nachdem es die Verzögerungseinheit verlassen hat.

8. Testsystem nach einem der Ansprüche 1 bis 7,
wobei die Reflexionseinheit (31, 41) einen Schalter (417) umfasst, der konfiguriert ist, um
- das erste Testsignal (43) zu unterbrechen, damit es nicht an die Verzögerungseinheit (411) weitergeleitet wird, und/oder
- das zweite Testsignal (44) zu unterbrechen, damit es nicht an den Ausgang (412) weitergeleitet wird.

9. Testsystem nach Anspruch 8,
wobei der Schalter (417) so konfiguriert ist, dass er das Unterbrechen basierend auf einem Unterbrechungssignal durchführt, das durch die Reflexionsvorrichtung von der zu testenden Vorrichtung (32, 42) und/oder dem Testmodul (320, 420) und/oder einer externen Schnittstelle empfangen wird.

10. Testsystem nach einem der Ansprüche 1 bis 9, wobei die Reflexionseinheit (31, 41) Folgendes umfasst:
- einen ersten Anschluss zum Empfangen des ersten Testsignals (33, 43), und
- einen zweiten Anschluss zum Senden des zweiten Testsignals (34, 44).

11. Testsystem nach einem der Ansprüche 1 bis 10, wobei die Verzögerungseinheit (50, 311, 411) eine Anpassungseinheit umfasst, die konfiguriert ist, um eine Verzögerungszeit zwischen dem ersten Testsignal (33, 43) und dem zweiten Testsignal (34, 44) anzupassen.

12. Testsystem nach Anspruch 11,
wobei die Anpassungseinheit konfiguriert ist, um die Zeit zwischen dem ersten Testsignal (33, 43) und dem zweiten Testsignal (34, 44) basierend auf einem Verzögerungszeitsignal anzupassen, das durch die Reflexionsvorrichtung von der zu testenden Vorrichtung (32, 42) und/oder dem Testmodul (320, 420) und/oder einer externen Schnittstelle empfangen wird.

13. Testverfahren zum Testen von drahtlosen Kommunikationsvorrichtungen, umfassend
- Senden (600), durch eine zu testende Vorrichtung (32, 42), eines ersten Testsignals (33, 43) an eine Reflexionseinheit (31, 41),
- Empfangen (601), durch die Reflexionseinheit (31, 41), des ersten Testsignals (33, 43),
- Verzögern (602), durch eine Verzögerungseinheit (50, 311, 411) in der Reflexionseinheit (31, 41), des ersten Testsignals (33, 43), was zu dem zweiten Testsignal (34, 44) führt,
wobei die Verzögerungseinheit (50, 311, 411) eine optische Verzögerungseinheit (50, 311, 411) ist, die einen elektrisch-optischen Analogwandler (501), der zum Umwandeln des ersten Testsignals (33, 43) in ein erstes optisches Signal konfiguriert ist, eine optische Verzögerungsleitung (502), die zum Verzögern des ersten optischen Signals konfiguriert ist, was zu einem zweiten optischen Signal führt, und einen optisch-elektrischen Analogwandler (503) umfasst, der zum Umwandeln des zweiten optischen Signals in das zweite Testsignal (34, 44) konfiguriert ist;
- Senden (603), durch die Reflexionseinheit (31, 41), des zweiten Testsignals (34, 44) an die zu testende Vorrichtung (32, 42), und
- Empfangen (604) des zweiten Testsignals (34, 44) durch die zu testende Vorrichtung (32, 42).

14. Computerprogramm mit einem Programmcode zum Durchführen aller Schritte des Testverfahrens nach Anspruch 13, wenn der Computerprogrammcode auf einen Computer oder einen digitalen Signalprozessor geladen und ausgeführt wird, der mit der Reflexionseinheit (31, 41), der zu testenden Vorrichtung (32, 42) und einem Testmodul (320, 420) verbunden ist.

## Revendications

1. Système de test permettant de tester des dispositifs de communication sans fil, comprenant :
- une unité de réflexion (31, 41), et
- un dispositif à tester (32, 42) qui comprend un module de test (320, 420) et qui est configuré pour :
- transmettre un premier signal de test (33, 43) à l'unité de réflexion (31, 41), et
- recevoir un second signal de test (34, 44) en provenance de l'unité de réflexion (31, 41),
dans lequel l'unité de réflexion (31, 41) comprend :
- une entrée (310, 410) configurée pour recevoir le premier signal de test (33, 43) en provenance du module de test (320, 420),
- une unité de retard (50, 311, 411) configurée pour retarder le premier signal de test (33, 43), d'où il résulte le second signal de test (34, 44), et
- une sortie (312, 412) configurée pour transmettre le second signal de test (34, 44) au module de test (320, 420),
**caractérisé en ce que** l'unité de retard (50, 311, 411) est une unité de retard optique (50, 311, 411), comprenant :
- un convertisseur électrique-optique analogique (501) configuré pour convertir le premier signal de test (33, 43) en un premier signal optique,
- une ligne de retard optique (502) configurée pour retarder le premier signal optique, d'où il résulte un second signal optique, et
- un convertisseur optique-électrique analogique (503) configuré pour convertir le second signal optique en second signal de test (34, 44).

2. Système de test selon la revendication 1,
dans lequel le module de test (320, 420) est configuré pour déterminer un résultat de test, sur la base du second signal de test (34, 44) ou d'une comparaison du premier signal de test (33, 43) et du second signal de test (34, 44).

3. Système de test selon la revendication 1 ou 2,
dans lequel l'unité de retard (50, 311, 411) est une unité de retard analogique (50, 311, 411).

4. Système de test selon l'une quelconque des revendications 1 à 3,
dans lequel l'unité de retard (311, 411) est une unité de retard électrique (311, 411), en particulier un filtre ou un condensateur.

5. Système de test selon l'une quelconque des revendications 1 à 4,
dans lequel le dispositif à tester (32, 42) et l'unité de retard (50, 311, 411) sont synchronisés, et
dans lequel le module de test (320, 420) est configuré pour ne transmettre aucun autre signal, jusqu'à ce que le second signal de test (34, 44) ait été reçu.

6. Système de test selon l'une quelconque des revendications 1 à 5,
dans lequel l'unité de réflexion (31, 41) comprend un amplificateur (416) configuré pour amplifier :
- le premier signal de test avant qu'il entre dans l'unité de retard, ou
- le second signal de test (44) après qu'il a quitté l'unité de retard (411).

7. Système de test selon l'une quelconque des revendications 1 à 6,
dans lequel l'unité de réflexion (31, 41) comprend un mélangeur (414) configuré pour décaler :
- le premier signal de test (43) vers une fréquence différente avant qu'il entre dans l'unité de retard (411), ou
- le second signal de test vers une fréquence différente après qu'il a quitté l'unité de retard.

8. Système de test selon l'une quelconque des revendications 1 à 7,
dans lequel l'unité de réflexion (31, 41) comprend un commutateur (417) configuré pour interrompre :
- le transfert du premier signal de test (43) à l'unité de retard (411), et/ou
- le transfert du second signal de test (44) à la sortie (412).

9. Système de test selon la revendication 8,
dans lequel le commutateur (417) est configuré pour réaliser l'interruption sur la base d'un signal d'interruption reçu par le dispositif de réflexion, en provenance du dispositif à tester (32, 42) et/ou du module de test (320, 420) et/ou d'une interface externe.

10. Système de test selon l'une quelconque des revendications 1 à 9,
dans lequel l'unité de réflexion (31, 41) comprend :
- un premier port permettant de recevoir le premier signal de test (33, 43), et
- un second port permettant de transmettre le second signal de test (34, 44).

11. Système de test selon l'une quelconque des revendications 1 à 10,
dans lequel l'unité de retard (50, 311, 411) comprend une unité de réglage, configurée pour régler un temps de retard entre le premier signal de test (33, 43) et le second signal de test (34, 44).

12. Système de test selon la revendication 11,
dans lequel l'unité de réglage est configurée pour régler le temps entre le premier signal de test (33, 43) et le second signal de test (34, 44), sur la base d'un signal de temps de retard reçu par le dispositif de réflexion en provenance du dispositif à tester (32, 42) et/ou du module de test (320, 420) et/ou d'une interface externe.

13. Procédé de test permettant de tester des dispositifs de communication sans fil, comprenant les étapes suivantes :
- transmettre (600), au moyen d'un dispositif à tester (32, 42), un premier signal de test (33, 43) à une unité de réflexion (31, 41),
- recevoir (601), au moyen de l'unité de réflexion (31, 41), le premier signal de test (33, 43),
- retarder (602), au moyen d'une unité de retard (50, 311, 411) dans l'unité de réflexion (31, 41), le premier signal de test (33, 43), d'où il résulte un second signal de test (34, 44),
dans lequel l'unité de retard (50, 311, 411) est une unité de retard optique (50, 311, 411), comprenant un convertisseur électrique-optique analogique (501) configuré pour convertir le premier signal de test (33, 43) en un premier signal optique, une ligne de retard optique (502) configurée pour retarder le premier signal optique, d'où il résulte un second signal optique, et un convertisseur optique-électrique analogique (503) configuré pour convertir le second signal optique en second signal de test (34, 44) ;
- transmettre (603), au moyen de l'unité de réflexion (31, 41), le second signal de test (34, 44) au dispositif à tester (32, 42), et
- recevoir (604), au moyen du dispositif à tester (32, 42), le second signal de test (34, 44).

14. Programme informatique ayant un code de programme permettant d'effectuer toutes les étapes du procédé de test selon la revendication 13, lorsque le code de programme informatique est chargé et s'exécute sur un ordinateur ou un processeur de signaux numériques qui est connecté à l'unité de réflexion (31, 41), au dispositif à tester (32, 42) et au module de test (320, 420).
